# EUROPÄISCHE PATENTSCHRIFT

(11) **EP 1 464 908 B1**
(45) Veröffentlichungstag und Bekanntmachung des Hinweises auf die Patenterteilung: **06.01.2010**
(21) Anmeldenummer: 04004158.4
(22) Anmeldetag: 24.02.2004
(51) Int. Cl.: F28F 9/00

(54) **Fixierung einer Wärmetauscherkassette**
Fixing device for a heat exchanger box
Fixation pour une cassette d'échangeur de chaleur

(30) Priorität: 04.04.2003 DE 10315753
(43) Veröffentlichungstag der Anmeldung: 06.10.2004
(73) Patentinhaber: Rittal GmbH & Co. KG, 35745 Herborn (DE)
(72) Erfinder: Immel, Manfred, 35756 Mittenaar (DE); Hartmann, Reiner, 35435 Wettenberg (DE); Maul, Joachim Dr., 35630 Ehringshausen (DE)
(74) Vertreter: Fleck, Hermann-Josef

(56) Entgegenhaltungen:
- DE-A1- 19 701 100
- US-B1- 6 170 562
- US-B1- 6 494 252

## Beschreibung

Die Erfindung betrifft eine Vorrichtung zur Fixierung und Abdichtung einer auswechselbaren Wärmetauscherkassette in einem Luft/Luft-Wärmetauscher gemäss dem Oberbegriff des Patentanspruchs 1, wobei mittels Trennstegen und der Wärmetauscherkassette zwei räumlich voneinander getrennte Leitungsbereiche gebildet sind. Eine derartige Vorrichtung ist zum Beispiel aus der US-6494252 bekannt.

Solche Luft/Luft-Wärmetauscher werden häufig zur Klimatisierung von Gehäusen für Telekommunikationsanlagen, IT-Technologie, Verkehrsleittechnik, Industrieaußenanlagen, Umwelttechnik und Energieverteilung eingesetzt. Dazu kann der Wärmetauscher an verschiedenen Positionen des Gehäuses wie an der Tür, an einer der Seitenwände oder auf dem Dach montiert werden.

Ein wichtiges Merkmal des Wärmetauschers ist, dass entsprechend der ausgewiesenen Schutzart keine Feuchtigkeit oder Staub in das Innere des Gehäuses übertragen wird. Dazu weisen Luft/Luft-Wärmetauscher einen Innen- und einen davon getrennten Außenluftkreislauf auf. Diesen ist zum Lufttransport jeweils ein Lüfter zugeordnet. Die Wärme wird in einer Wärmetauscherkassette, die in getrennten Kanälen beziehungsweise Lamellen von den beiden Luftströmen durchströmt wird, vom Innenluftkreis auf den Außenluftkreis übertragen. Dabei ist es wichtig, dass die beiden Luftkreisläufe gegeneinander ausreichend abgedichtet sind.

Um eine ausreichende Wärmeübertragung zu gewährleisten, ist es notwendig, die Wärmetauscherkassette in von den jeweiligen Umweltbedingungen am Einsatzort abhängigen Intervallen zu reinigen. Dazu wird die Wärmetauscherkassette aus dem Luft/Luft-Warmetauscher entnommen:

Die Dichtelemente zwischen der Wärmetauscherkassette und dem Gehäuse des Luft/Luft-Wärmetauschers dürfen durch den Aus- und Einbau ihre Dichtwirkung nicht verlieren. Daher werden in heutigen Luft/Luft-Wärmetauschern die Wärmetauscherkassetten eingeklebt oder mittels geschraubten Zusatzwinkeln befestigt.

Bei der geklebten Ausführung mit ihrer sehr guten Dichtwirkung hat es sich als nachteilig erwiesen, dass die Klebeverbindung zum Ausbau der Wärmetauscherkassette nur aufwändig zu trennen ist. Der Montageaufwand zum Einkleben der Wärmetauscherkassette beim Einbau ist ebenfalls sehr hoch.

Auch der Aus- und Einbau der Wärmetauscherkassette bei Anlagen mit geschraubten Zusatzwinkeln ist mit einem erhöhten Montageaufwand verbunden.

Es ist Aufgabe der Erfindung, eine Fixierung und Abdichtung einer Wärmetauscherkassette der eingangs erwähnten Art zu schaffen, welche einen einfachen und sicheren Ein- und Ausbau der Wärmetauscherkassette ermöglicht.

Die Aufgabe der Erfindung wird dadurch gelöst, dass der Luft/Luft-Wärmetauscher im Bereich seiner Trennstege Dichtsitze aufweist, dass die Wärmetauscherkassette mit Dichtflächen an den Dichtsitzen anliegt, und dass der Luft/Luft-Wärmetauscher mindestens einen beweglichen Schieber aufweist, der die Wärmetauscherkassette vorgespannt in den Dichtsitzen hält. Durch den Schieber wird eine leicht lösbare Halterung der Wärmetauscherkassette ermöglicht. Dadurch, dass die Wärmetauscherkassette durch den Schieber gegen die Dichtsitze gedrückt wird, ist an den zugeordneten Kanten der Wärmetauscherkassette eine gut abdichtende, aber dennoch leicht und wiederholt lösbare Trennstelle zwischen den Kammern des Innenluftkreislaufes und denen des Außenluftkreislaufes des Luft/Luft-Wärmetauschers gegeben.

In einer bevorzugten Ausgestaltungsvariante der Erfindung ist der Schieber mittels eines Exzenterhebels betätigbar. Mit Hilfe des Exzenterhebels kann der Schieber mit geringem Kraftaufwand fest an die Wärmetauscherkassette gedrückt werden. Dadurch kann die Wärmetauscherkassette mit geringem Aufwand montiert und mit ausreichender Anpresskraft gegen die Dichtsitze gedrückt werden.

Eine gleichmäßige Anpresskraft über die gesamte Länge der Dichtflächen gegen die Dichtsitze wird dadurch erreicht, dass der Einwirkpunkt des Exzenterhebels quer zur Versatzrichtung des Schiebers in der Mitte des Schiebers positioniert ist. Weiterhin wird so ein Verkanten des Schiebers beim Anziehen des Exzenters verhindert.

Gemäß einer bevorzugten Ausführung der Erfindung ist es vorgesehen, dass der Schieber an einem der Trennstege befestigt ist und einen Überbruckungsabschnitt aufweist, dass der Überbrückungsabschnitt eine Dichtung trägt, die an einer zugeordneten Dichtfläche der Wärmetauscherkassette anliegt, und dass der Überbrückungsabschnitt und die Dichtung den Übergangsbereich zwischen dem freien Ende des Trennsteges und der Wärmetauscherkassette überbrücken.
Mit dieser einfachen Maßnahme trennt der Schieber im geschlossenen Zustand in Verlängerung des Trennsteges die beiden benachbarten die Luftführungskanäle bildenden Kammern des Luft/Luft-Wärmetauschers ab.

Eine leichte Verschiebung des Schiebers im gelösten Zustand und eine sichere Fixierung des Exzenters und somit des Schiebers im Einbauzustand der Wärmetauscherkassette wird dadurch erreicht, dass der Schieber als Schiebeführung einen langlochartigen Durchbruch aufweist, dass der Durchbruch fluchtend zu einer Aufnahme in dem Trennsteg und einer Aufnahme des Exzenterhebels angeordnet ist, und dass eine Befestigungsschraube durch den Durchbruch des Schiebers und die Aufnahmen des Trennsteges und des Exzenterhebels hindurchgeführt und mit einer Mutter gekontert ist.

Ein kostengünstiger Aufbau sowie eine gute Abdichtung zwischen den Dichtflächen der Wärmetauscherkassette und den korrespondierenden Dichtsitzen ergibt sich dadurch, dass die Dichtsitze mittels an die Dichtflächen der Wärmetauscherkassette angepasste Flächen an den Trennstegen gebildet sind und zwischen den Dichtsitzen und den Dichtflächen Dichtungen angeordnet sind.

Um beim Einbau eine schnelle und genaue Positionierung der Wärmetauscherkassette bei gleichzeitiger guten Abdichtung im Bereich zwischen dem Schieber und der Wärmetauscherkassette zu gewährleisten kann es vorgesehen werden, dass zwischen dem Schieber und der als Dichtfläche ausgebildeten zugeordneten Kante der Wärmetauscherkassette eine Dichtung mit einem vorzugsweise V-förmigen Profil angeordnet ist.

Eine sehr gute Abdichtung der dem Schieber zugeordneten Seite der Wärmetauscherkassette wird dadurch erreicht, dass der Schieber und die Dichtungen die gleiche Höhe wie die Wärmetauscherkassette aufweisen.

In einer bevorzugten Ausführungsform sind die Dichtungen fest an dem Schieber und den Dichtsitzen angebracht sind. Dies ermöglicht einen schnellen Ein- und Ausbau der Wärmetauscherkassette ohne zusätzlichen Montageaufwand zur Positionierung der Dichtungen.

In einer weiteren bevorzugten Ausführungsform sind die Dichtungen fest an den Dichtflächen der Wärmetauscherkassette angebracht. Auch dies ermöglicht einen schnellen Ein- und Ausbau der Warmetauscherkassette ohne zusätzlichen Montageaufwand zur Positionierung der Dichtungen. Weiterhin werden bei dieser Ausführungsform die Dichtungen bei einem Ersatz der Wärmetauscherkassette mit erneuert.

Ein kostengünstiger Aufbau des Luft/Luft-Wärmetauschers bei gleichzeitig guter Dichtwirkung zwischen den Leitungsbereichen wird dadurch erreicht, dass der Luft/Luft-Wärmetauscher einen Gehäuseboden aufweist, auf dem sich die Wärmetauscherkassette mit einer Seitenfläche dichtend abstützt, dass die Trennstege an den Gehäuseboden angeschlossen sind und von diesem aufsteigen, dass die Trennstege die sich zueinander parallel erstreckenden Dichtsitze tragen, dass der Schieber im wesentlichen senkrecht zur Längserstreckung der Dichtsitze verstellbar ist, dass parallel zum Gehäuseboden ein Gehäusedeckel den Luft/Luft-Wärmetauscher verschließt, und dass der Gehäusedeckel abgedichtet auf der dem Gehäuseboden abgekehrten Seite der Wärmetauscherkassette aufsitzt.

Eine bevorzugte Erfindungsvariante sieht vor, dass die Warmetauscherkassette in Draufsicht symmetnsch aufgebaut ist. Dadurch kann die Wärmetauscherkassette ohne Verwechslungsgefahr beliebig in eine der vier möglichen Positionen eingebaut werden.

Die Erfindung wird im folgenden anhand eines in den Figuren dargestellten Ausführungsbeispiels näher erläutert. Es zeigen:
- Fig. 1: einen Luft/Luft-Wärmetauscher mit einer Wärmetauscherkassette in Draufsicht
- Fig. 2: den Luft/Luft-Wärmetauscher gemäß Fig. 1 in Ansicht auf den in Fig. 1 mit II-II bezeichneten Schnittverlauf
- Fig.3: den Luft/Luft-Wärmetauscher gemäß Fig. 1 und 2 einer veranderten Montagestellung und in in Draufsicht
- Fig. 4: den Luft/Luft-Wärmetauscher gemaß Fig. 3 in Ansicht auf den in Fig. 3 mit IV - IV gezeigten Schnittverlauf

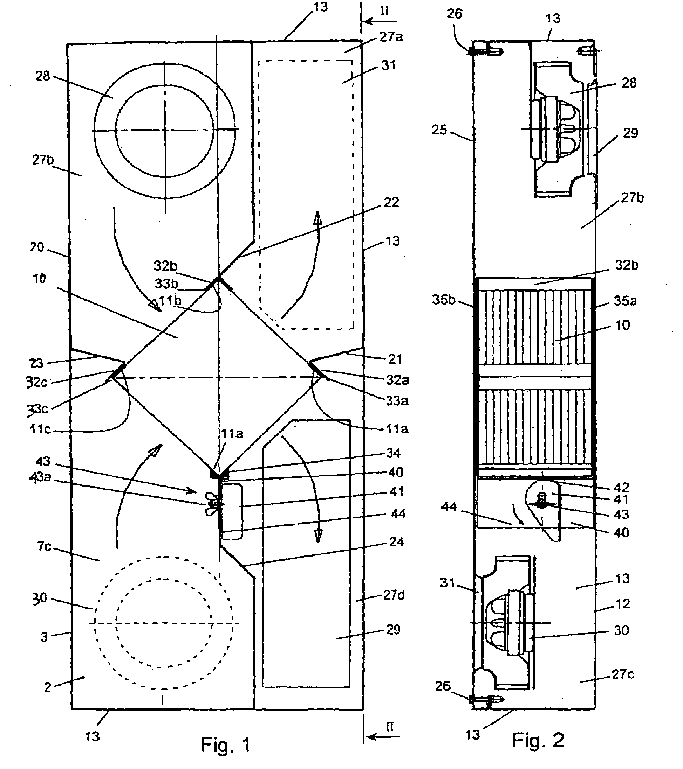

Die Figur 1 zeigt einen Luft/Luft-Wärmetauscher 20 in Draufsicht. Wie diese Darstellung erkennen lässt, weißt der Luft/Luft-Wärmetauscher 20 ein Gehäuse auf, das einen Gehäuseboden 12 und vier daran angeschlossene Seitenwände 13 aufweist Die offene Gehäuseseite kann, wie dies Figur 2 erkennen lässt, mit einem Gehäusedeckel 25 verschlossen werden. Der Gehäuseinnenraum ist mittels vier Trennstegen 21 bis 24 in vier Kammern 27 a-d unterteilt. Die Trennstege 21 bis 24 sind mit dem Gehäuseboden 12 und jeweils einer zugeordneten Seitenwand 13 luftdicht verbunden. Wie die Figur 2 erkennen lässt, erstrecken sich die Trennstege 21 bis 24 über die gesamte Höhe des Gehäuse-Innenraumes. An ihren freien Enden sind die Trennstege 21 bis 23 mit Dichtsitzen 32a-c ausgestattet. Der Trennsteg 22 bildet einen im Querschnitt V-förmigen Dichtsitz 32b. Die Trennstege 21 und 23 bilden jeweils einen flächigen Dichtsitz 32a und 32c.

Gegenüberliegend dem V-förmigen Dichtsitz 32b ist an dem freien Ende des Trennsteges 24 ein Schieber 40 angeordnet. Der Schieber weist einen plattenförmigen Stützabschnitt 44 auf, der seitlich an den Trennsteg 24 angelegt ist. Der Stützabschnitt 44 besitzt an seinem über das freie Ende des Trennsteges 24 hinaus ragenden Bereich einen Überbrückungsabschnitt, der mit einem im Querschnitt V-förmigen Dichtsitz abschließt. Der Dichtsitz liegt dem V-förmigen Dichtsitz 32b des Trennsteges 22 gegenüber. Auf die Dichtsitze 32 a-c der Trennstege 21 bis 23 und dem des Schiebers 40 sind Dichtungen 33 a-c bzw. 34 aufgebracht. Die Dichtungen 33 a-c und 34 erstrecken sich über die gesamte Höhe des Gehäuse-Innenraumes. In den zwischen den Dichtungen 33 a-c und 34 gebildeten Aufnahmeraum kann eine Wärmetauscherkassette 10 eingebaut werden. Die Warmetauscherkassette 10 weist mehrere zueinander parallele Lamellen auf, die Leitungsbereiche abtrennen. Dabei sind jeweils zwei Gruppen von Leitungsbereichen gebildet. Diese sind wechselweise zwei Luftführungsabschnitten des Luft/Luft-Wärmetauschers 20 zugeführt. Die Trennstege 21 bis 24 teilen vier Kammern 24 a-d im Gehäuseinnenraum ab. Jeweils zwei Kammern 27a und 27c bzw. 27b und 27d stehen miteinander über die Wärmetauscherkassette 10 in räumlicher Verbindung und bilden so einen Luftführungsabschnitt. Die beiden Luftführüngsabschnitte kreuzen sich im Bereich der Wärmetauscherkassette 10. Der erste Luftführungsabschnitt, der von den Kammern 27b und 27d gebildet wird, ist Teil eines Innenkreislaufes. Der zweite Luftführungsabschnitt, der von den Kammern 27a und 27c gebildet wird, ist Teil eines Außenkreislaufes. Der Innenkreislauf steht über Durchbrüche 29 im Gehäuseboden 12 der Kammern 27b und 27d in Verbindung mit dem Innenraum eines angeschlossenen Schaltschrankes. Der Außenkreislauf steht über Durchbrüche 31 in Verbindung mit der Umgebung. Je ein Durchbruch 29 und 31 des Innen- und des Außenkreislaufes ist ein Lüfter (Innenlüfter 28, Außenlüfter 30) zugeordnet. Diese fördern die im Innen- und Außenkreislauf geführte Luft.

Die Warmetauscherkassette 10 ist in der in Figur 1 gezeigten Montagestellung an den Dichtsitzen 32 a-c gehalten. Dabei presst der Schieber 40 unter Einwirkung einer Exzenterhebels 41 die Wärmetauscherkassette 10 gegen die Dichtungen 32 a-c und 34. Der Exzenterhebel 41 weist einen Durchbruch auf, der fluchtend zu einem Durchbruch des Trennsteges 24 angeordnet ist. In den Schieber 40 ist ein Langloch eingebracht. Durch die Durchbrüche und das Langloch kann eine Befestigungsschraube 43a hindurchgeführt und zur Bildung einer Schraubverbindung mit einer Flügelmutter gekontert werden. Zur Betätigung des Exzenterhebels 41 ist ein einteilig abgekanteter Griffabschnitt vorgesehen. An diesem kann der Exzenterhebel 41 verstellt werden. Dabei gelangt sein Exzenterabschnitt in Einriff mit einer Gegenfläche des Schiebers 40 und verstellt diesen in Richtung auf die Wärmetauscherkassette 10.

In der in den Figuren 1 und 2 gezeigten Endmontagestellung kann der Exzenterhebel 41 und gleichzeitig der Schieber 40 durch ein einfaches Anziehen der Schraubverbindung 43 arretiert werden. Die Wärmetauscherkassette 10 ist dann sicher in den Dichtungen 33 a-c und 34 gehalten. Abschließend kann der Gehäusedeckel 25 aufgesetzt und verschraubt werden (Schraubverbindungen 26). Auf der Innenseite des Gehäusedeckels 25 ist eine Dichtung 35b aufgebracht. Diese dichtet die freie Stirnseite der Wärmetauscherkassette 10 ab.

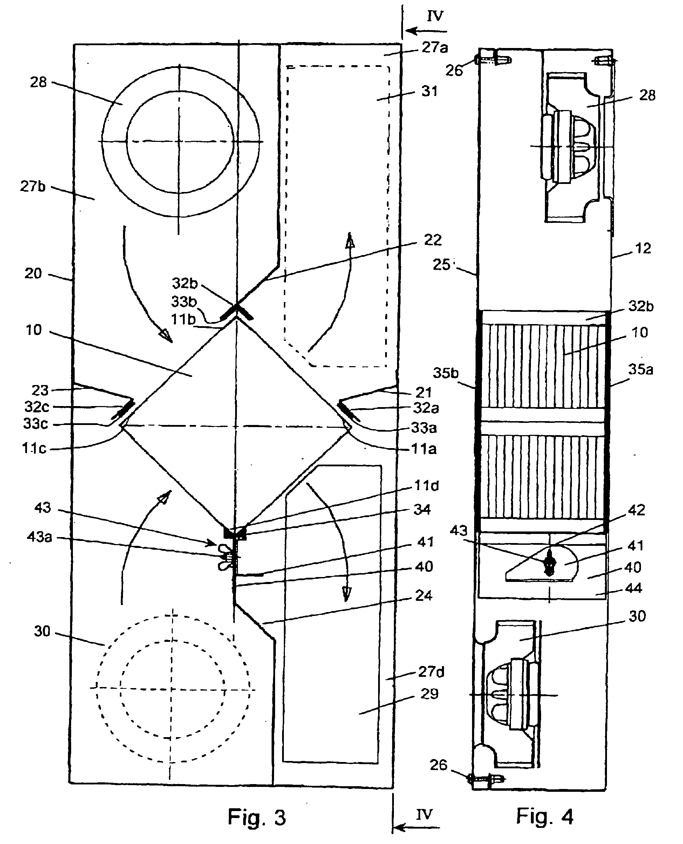

Zum Austausch der Wärmetauscherkassette 10 im Wartungsfall muss lediglich die Schraubverbindung 43 gelöst und der Exzenterhebel 41 in die Demontagestellung gebracht werden. Dann kann die gelöste Wärmetauscherkassette 10 entnommen werden. Die Demontagestellung ist in den Figuren 3 und 4 veranschaulicht.

## Patentansprüche

1. Vorrichtung zur Fixierung und Abdichtung einer auswechselbaren Wärmetauscherkassette (10) in einem Luft/Luft-Wärmetauscher (20), wobei mittels Trennstegen (21, 22, 23, 24) und der Wärmetauscherkassette (10) zwei räumlich voneinander getrennte Leitungsbereiche gebildet sind,
wobei der Luft/Luft-Wärmetauscher (20) im Bereich seiner Trennstege (21 bis 24) Dichtsitze (32 a-c) aufweist, dass die Wärmetauscherkassette (10) mit Dichtflächen (11a-d) an den Dichtsitzen anliegt, und **dadurch gekennzeichnet dass** der Luft/Luft-Wärmetauscher (20) mindestens einen beweglichen Schieber (40) aufweist, der die Wärmetauscherkassette vorgespannt in den Dichtsitzen (32 a-c) hält.

2. Vorrichtung nach Anspruch 1,
**dadurch gekennzeichnet,**
**dass** der Schieber (40) mittels eines Exzenterhebels (41) betätigbar ist.

3. Vorrichtung nach Anspruch 2,
**dadurch gekennzeichnet,**
**dass** der Einwirkpunkt (42) des Exzenterhebels (41) quer zur Versatzrichtung des Schiebers (40) in der Mitte des Schiebers (40) positioniert ist.

4. Vorrichtung nach einem der Ansprüche 1 bis 3,
**dadurch gekennzeichnet,**
**dass** der Schieber (40) an einem der Trennstege (21, 22, 23, 24) befestigt ist und einen Überbrückungsabschnitt aufweist, dass der Überbrückungsabschnitt eine Dichtung (34) trägt, die an einer zugeordneten Dichtfläche (11a) der Wärmetauscherkassette (10) anliegt, und dass der Überbrückungsabschnitt und die Dichtung (34) den Übergangsbereich zwischen dem freien Ende des Trennsteges (21-24) und der Wärmetauscherkassette (10) überbrücken.

5. Vorrichtung nach Anspruch 4,
**dadurch gekennzeichnet,**
**dass** der Schieber (40) als Schiebeführung einen langlochartigen Durchbruch aufweist, dass der Durchbruch fluchtend zu einer Aufnahme in dem Trennsteg (24) und einer Aufnahme des Exzenterhebel (41) angeordnet ist, und dass eine Befestigungsschraube (43a) durch den Durchbruch des Schiebers (40) und die Aufnahmen des Trennsteges (24) und des Exzenterhebels (41) hindurchgeführt und mit einer Mutter gekontert ist.

6. Vorrichtung nach einem der Ansprüche 1 bis 5,
**dadurch gekennzeichnet,**
**dass** die Dichtsitze (32a-c) mittels an die Dichtflächen (11a-c) der Wärmetauscherkassette (10) angepasste Flächen an den Trennstegen (21, 22, 23) gebildet sind und zwischen den Dichtsitzen (32a-c) und den Dichtflächen (11a-c) Dichtungen (33a-c) angeordnet sind.

7. Vorrichtung nach einem der Ansprüche 1 bis 6,
**dadurch gekennzeichnet,**
**dass** zwischen dem Schieber (40) und der als Dichtfläche (11d) ausgebildeten zugeordneten Kante der Wärmetauscherkassette (10) eine Dichtung (34) mit einem vorzugsweise V-förmigen Profil angeordnet ist.

8. Vorrichtung nach einem der Ansprüche 1 bis 7,
**dadurch gekennzeichnet,**
**dass** der Schieber (40) und die Dichtungen (33a-c, 34) die gleiche Höhe wie die Wärmetauscherkassette (10) aufweisen.

9. Vorrichtung nach einem der Ansprüche 1 bis 8,
**dadurch gekennzeichnet,**
**dass** die Dichtung (34) fest an dem Schieber (40) und die Dichtungen (33a-c) fest an den Dichtsitzen (32a-c) angebracht sind.

10. Vorrichtung nach einem der Ansprüche 1 bis 8,
**dadurch gekennzeichnet,**
**dass** die Dichtungen (33a-c, 34) fest an den Dichtfläche (11a-d) der Wärmetauscherkassette (10) angebracht sind.

11. Vorrichtung nach einem der Ansprüche 1 bis 10,
**dadurch gekennzeichnet,**
**dass** der Luft/Luft-Wärmetauscher (20) einen Gehäuseboden (12) aufweist, auf dem sich die Wärmetauscherkassette (10) mit einer Seitenfläche dichtend abstützt, dass die Trennstege (21-24) an den Gehäuseboden (12) angeschlossen sind und von diesem aufsteigen, dass die Trennstege (21-24) die sich zueinander parallel erstreckenden Dichtsitze (32 a-c) tragen, dass der Schieber (40) im wesentlichen senkrecht zur Längserstreckung der Dichtsitze (32 a-c) verstellbar ist, dass parallel zum Gehäuseboden (12) ein Gehäusedeckel (25) den Luft/Luft-Wärmetauscher verschließt, und dass der Gehäusedeckel (25) abgedichtet auf der dem Gehäuseboden (12) abgekehrten Seite der Wärmetauscherkassette (10) aufsitzt.

12. Vorrichtung nach einem der Ansprüche 1 bis 11,
**dadurch gekennzeichnet,**
**dass** die Wärmetauscherkassette (10) in Draufsicht symmetrisch aufgebaut ist.

## Claims

1. Device for fixing and sealing an exchangeable heat exchanger cassette (10) in an air/air heat exchanger (20), with two conduit regions which are spatially separate from one another being formed by means of separating webs (21, 22, 23, 24) and the heat exchanger cassette (10), with the air/air heat exchanger (20) having sealing seats (32a-c) in the region of its separating webs (21 to 24), and with the heat exchanger cassette (10) bearing with sealing surfaces (11a-d) against the sealing seats, **characterized in that** the air/air heat exchanger (20) has at least one movable slide (40) which holds the heat exchanger cassette preloaded in the sealing seats (32a-c).

2. Device according to Claim 1,
**characterized**
**in that** the slide (40) can be actuated by means of an eccentric lever (41).

3. Device according to Claim 2,
**characterized**
**in that** the action point (42) of the eccentric lever (41) is positioned, transversely with respect to the displacement direction of the slide (40), in the centre of the slide (40).

4. Device according to one of Claims 1 to 3,
**characterized**
**in that** the slide (40) is fastened to one of the separating webs (21, 22, 23, 24) and has a bridging section, in that the bridging section carries a seal (34) which bears against an associated sealing surface (11a) of the heat exchanger cassette (10), and in that the bridging section and the seal (34) bridge the transition region between the free end of the separating web (21-24) and the heat exchanger cassette (10).

5. Device according to Claim 4,
**characterized**
**in that** the slide (40), as a sliding guide, has a slot-like aperture, in that the aperture is arranged in alignment with a receptacle in the separating web (24) and a receptacle of the eccentric lever (41), and in that a fastening screw (43a) extends through the aperture of the slide (40) and the receptacles of the separating web (24) and of the eccentric lever (41) and is locked by means of a nut.

6. Device according to one of Claims 1 to 5,
**characterized**
**in that** the sealing seats (32a-c) are formed by means of surfaces, which are matched to the sealing surfaces (11a-c) of the heat exchanger cassette (10), on the separating webs (21, 22, 23), and seals (33a-c) are arranged between the sealing seats (32a-c) and the sealing surfaces (11a-c).

7. Device according to one of Claims 1 to 6,
**characterized**
**in that** a seal (34) having a preferably V-shaped profile is arranged between the slide (40) and the associated edge, which is designed as a sealing surface (11d), of the heat exchanger cassette (10).

8. Device according to one of Claims 1 to 7,
**characterized**
**in that** the slide (40) and the seals (33a-c, 34) are of the same height as the heat exchanger cassette (10).

9. Device according to one of Claims 1 to 8,
**characterized**
**in that** the seal (34) is fixedly attached to the slide (40) and the seals (33a-c) are fixedly attached to the sealing seats (32a-c).

10. Device according to one of Claims 1 to 8,
**characterized**
**in that** the seals (33a-c, 34) are fixedly attached to the sealing surfaces (11a-d) of the heat exchanger cassette (10).

11. Device according to one of Claims 1 to 10,
**characterized**
**in that** the air/air heat exchanger (20) has a housing base (12) on which the heat exchanger cassette (10) is sealingly supported with a side surface, in that the separating webs (21-24) are connected to the housing base (12) and extend upward from the latter, in that the separating webs (21-24) carry the sealing seats (32a-c) which extend parallel to one another, in that the slide (40) can be adjusted substantially perpendicular to the longitudinal extent of the sealing seats (32a-c), in that a housing cover (25) closes off the air/air heat exchanger parallel to the housing base (12), and in that the housing cover (25) is seated in a sealed fashion on that side of the heat exchanger cassette (10) which faces away from the housing base (12).

12. Device according to one of Claims 1 to 11,
**characterized**
**in that** the heat exchanger cassette (10) is of symmetrical design in plan view.

## Revendications

1. Dispositif de fixation et d'étanchéité d'une cassette d'échangeur de chaleur remplaçable (10) dans un échangeur de chaleur air/air (20), dans lequel deux zones de conduite spatialement séparées l'une de l'autre sont formées au moyen de cloisons de séparation (21, 22, 23, 24) et de la cassette d'échangeur de chaleur (10), dans lequel l'échangeur de chaleur air/air (20) présente des sièges d'étanchéité (32a-c) dans la région de ses cloisons de séparation (21 à 24), la cassette d'échangeur de chaleur (10) repose par des faces d'étanchéité (11a-d) sur les sièges d'étanchéité, **caractérisé en ce que** l'échangeur de chaleur air/air (20) présente au moins un coulisseau mobile (40), qui maintient la cassette d'échangeur de chaleur sous précontrainte dans les sièges d'étanchéité (32a-c).

2. Dispositif selon la revendication 1, **caractérisé en ce que** le coulisseau (40) peut être actionné au moyen d'un levier excentrique (41).

3. Dispositif selon la revendication 2, **caractérisé en ce que** le point d'action (42) du levier excentrique (41) est positionné au milieu du coulisseau (40), transversalement à la direction de déplacement du coulisseau (40).

4. Dispositif selon l'une quelconque des revendications 1 à 3, **caractérisé en ce que** le coulisseau (40) est fixé sur une cloison de séparation (21, 22, 23, 24) et présente une partie de franchissement, **en ce que** la partie de franchissement porte un joint d'étanchéité (34), qui est appliqué sur une face d'étanchéité associée (11a) de la cassette d'échangeur de chaleur (10), et **en ce que** la partie de franchissement et le joint d'étanchéité (34) enjambent la région de transition entre l'extrémité libre de la cloison de séparation (21-24) et la cassette d'échangeur de chaleur (10).

5. Dispositif selon la revendication 4, **caractérisé en ce que** le coulisseau (40) présente un passage en forme de trou oblong comme guide de déplacement, **en ce que** le passage est disposé en alignement avec un logement dans la cloison de séparation (24) et un logement du levier excentrique (41), et **en ce qu'**une vis de fixation (43a) est menée à travers le passage du coulisseau (40) et les logements de la cloison de séparation (24) et du levier excentrique (41) et est bloquée au moyen d'un contre-écrou.

6. Dispositif selon l'une quelconque des revendications 1 à 5, **caractérisé en ce que** les sièges d'étanchéité (32a-c) sont formés par des faces des cloisons de séparation (21, 22, 23) adaptées aux faces d'étanchéité (11a-c) de la cassette d'échangeur de chaleur (10) et des joints d'étanchéité (33a-c) sont disposés entre les sièges d'étanchéité (32a-c) et les faces d'étanchéité (11a-c).

7. Dispositif selon l'une quelconque des revendications 1 à 6, **caractérisé en ce qu'**un joint d'étanchéité (34) avec un profil de préférence en forme de V est disposé entre le coulisseau (40) et l'arête associée de la cassette d'échangeur de chaleur (10) se présentant sous la forme d'une face d'étanchéité (11d).

8. Dispositif selon l'une quelconque des revendications 1 à 7, **caractérisé en ce que** le coulisseau (40) et les joints d'étanchéité (33a-c, 34) présentent la même hauteur que la cassette d'échangeur de chaleur (10).

9. Dispositif selon l'une quelconque des revendications 1 à 8, **caractérisé en ce que** le joint d'étanchéité (34) est placé de façon solidaire sur le coulisseau (40) et les joints d'étanchéité (33a-c) sont placés de façon solidaire sur les sièges d'étanchéité (32a-c).

10. Dispositif selon l'une quelconque des revendications 1 à 8, **caractérisé en ce que** les joints d'étanchéité (33a-c, 34) sont placés de façon solidaire sur les faces d'étanchéité (11a-d) de la cassette d'échangeur de chaleur (10).

11. Dispositif selon l'une quelconque des revendications 1 à 10, **caractérisé en ce que** l'échangeur de chaleur air/air (20) présente un fond de boîtier (12) sur lequel la cassette d'échangeur de chaleur (10) s'appuie de façon étanche par une face latérale, **en ce que** les cloisons de séparation (21-24) sont raccordées au fond de boîtier (12) et sont dressées sur celui-ci, **en ce que** les cloisons de séparation (21-24) portent les sièges d'étanchéité (32a-c) s'étendant parallèlement l'un à l'autre, **en ce que** le coulisseau (40) est déplaçable en direction essentiellement perpendiculaire à l'extension longitudinale des sièges d'étanchéité (32a-c), **en ce qu'**un couvercle de boîtier (25) ferme l'échangeur de chaleur air/air parallèlement au fond de boîtier (12), et **en ce que** le couvercle de boîtier (25) repose de façon étanche sur le côté de la cassette d'échangeur de chaleur (10) situé à l'opposé du fond de boîtier (12).

12. Dispositif selon l'une quelconque des revendications 1 à 11, **caractérisé en ce que** la cassette d'échangeur de chaleur (10) a une structure symétrique dans une vue en plan.
